(19) Europäisches Patentamt
European Patent Office
Office européen des brevets

(11) **EP 4 052 310 B1**

(12) **EUROPÄISCHE PATENTSCHRIFT**

(45) Veröffentlichungstag und Bekanntmachung des Hinweises auf die Patenterteilung:
**28.01.2026 Patentblatt 2026/05**

(21) Anmeldenummer: **19795537.0**

(22) Anmeldetag: **28.10.2019**

(51) Internationale Patentklassifikation (IPC):
**H10H 20/851** (2025.01) **H10K 50/115** (2023.01)

(52) Gemeinsame Patentklassifikation (CPC):
**H10K 50/115; H10K 50/868; H10K 71/00;**
H10K 50/805; H10K 71/80

(86) Internationale Anmeldenummer:
**PCT/EP2019/079361**

(87) Internationale Veröffentlichungsnummer:
**WO 2021/083477 (06.05.2021 Gazette 2021/18)**

(54) **VERFAHREN ZUR HERSTELLUNG EINER POLARISIERT EMITTIERENDEN LEUCHTDIODE**

METHOD FOR PRODUCING A LIGHT-EMITTING DIODE HAVING POLARIZED EMISSION

PROCÉDÉ DE PRODUCTION D'UNE DIODE ÉLECTROLUMINESCENTE À ÉMISSION POLARISÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.09.2022 Patentblatt 2022/36**

(73) Patentinhaber: **Fraunhofer-Gesellschaft zur Förderung
der angewandten Forschung e.V.
80686 München (DE)**

(72) Erfinder:
• **SCHLICKE, Hendrik**
**20146 Hamburg (DE)**
• **NIEHAUS, Jan**
**20146 Hamburg (DE)**
• **REICH, Christoph**
**20146 Hamburg (DE)**

(56) Entgegenhaltungen:
**US-A1- 2016 137 920    US-A1- 2019 165 291**

• **R. A. M. HIKMET ET AL: "Polarized-Light-Emitting Quantum-Rod Diodes", ADVANCED MATERIALS, vol. 17, no. 11, 6 June 2005 (2005-06-06), pages 1436 - 1439, XP055037469, ISSN: 0935-9648, DOI: 10.1002/adma.200401763**
• **YORAI AMIT ET AL: "Semiconductor nanorod layers aligned through mechanical rubbing", PHYSICA STATUS SOLIDI. A: APPLICATIONS AND MATERIALS SCIENCE, vol. 209, no. 2, 6 November 2011 (2011-11-06), DE, pages 235 - 242, XP055715072, ISSN: 1862-6300, DOI: 10.1002/pssa.201127572**

**Beschreibung**

Die vorliegende Erfindung betrifft ein Verfahren zur Herstellung einer Leuchtdiode ("LED"), die polarisiertes Licht mit hohem Polarisationsgrad emittiert.

Die Verwendung kolloidaler Halbleiter-Nanopartikel im Bereich der Displaytechnologie ist bekannt. Durch Variation der Form, Größe und Zusammensetzung der Halbleiter-Nanopartikel lassen sich deren optoelektronische Eigenschaften gezielt einstellen. Halbleiter-Nanopartikel zeichnen sich durch ein enges Emissionsspektrum bei hoher Quantenausbeute aus. Die Emission kann durch optische Anregung (Photolumineszenz) oder Ladungsinjektion (Elektrolumineszenz) ausgelöst werden.

Eine Übersicht zu Halbleiter-Nanopartikeln und deren Anwendung in der Displaytechnologie findet sich bei U. Banin et al., Angew. Chem., 2018, 130, S. 4354-4376.

Bei der Anwendung von Halbleiter-Nanopartikeln für Displayanwendungen kann zwischen zwei grundlegenden Prinzipien unterschieden werden. Zum einen kann die Photolumineszenz der Halbleiter-Nanokristalle ausgenutzt werden, indem sie mit kürzerwelligem Licht angeregt werden. Zum anderen können die Halbleiter-Nanokristalle (z.B. als Komponente in LEDs) durch die direkte Umwandlung elektrischer Energie in Licht elektrolumineszent betrieben werden.

Bei einigen aktuellen Flüsigkristall-Dispays (LCDs) sind die Halbleiter-Nanopartikel beispielsweise Bestandteil der Hintergrundbeleuchtungseinheit. Durch eine von einer LED (z.B. einer blauen LED) emittierten Strahlung werden die Halbleiter-Nanopartikel zu einer Photolumineszenz angeregt. Diese von den Halbleiter-Nanopartikeln emittierte Strahlung und die von der LED emittierte Strahlung können sich beispielsweise zu einem weißen Licht mischen, das der Flüsigkristall-haltigen Zelle zugeführt wird.

In den "Quantenpunkt"-LEDs liegen die Halbleiter-Nanopartikel in der Emitterschicht zwischen den Elektroden und gegebenenfalls weiteren funktionalen Schichten (wie z.B. Elektronentransportschichten, Lochtransportschichten, Lochinjektionsschichten, Elektroneninjektionsschichten, etc.) vor.

Über bekannte Syntheseverfahren (z.B. nasschemische Verfahren) lassen sich Halbleiter-Nanopartikel definierter Größe und Form herstellen. Durch Einstellung geeigneter Synthesebedingungen können selektiv kugelförmige, elongierte (z.B. stäbchenförmige oder drahtförmige), plättchenförmige Nanopartikel oder auch Nanopartikel mit komplexen Geometrien mit enger Größenverteilung erhalten werden. Weiterhin ist bekannt, dass sich die optoelektronischen Eigenschaften durch Verwendung heterostrukturierter Halbleiter-Nanopartikel (z.B. in Form einer Kern-Schale-Struktur) gezielt beeinflussen lassen.

Polarisiertes (z.B. linear oder zirkular polarisiertes) Licht spielt in verschiedenen Anwendungsfeldern wie z.B. der Displaytechnologie (z.B. 3D-Projektion, Holographie oder den sogenannten Head-Up-Displays ("*HUDs*") in der Mobilitätsindustrie) und der Wissenschaft eine wichtige Rolle.

Die Erzeugung linear polarisierten Lichts kann beispielsweise durch das Filtern von Licht einer unpolarisiert emittierenden Lichtquelle mittels eines linearen Polarisationsfilters erfolgen. Dieses Konzept erreicht zwar hohe Polarisationsgrade, ist aber ineffizient, da Licht mit abweichender Polarisationsebene zuerst erzeugt und dann vom Filter geblockt wird. Laser emittieren zwar polarisiertes Licht, sind allerdings für flächige Beleuchtungsanwendungen nicht geeignet.

Effizientere polarisiert-emittierende Lichtquellen können erhalten werden, wenn ein Emitter verwendet wird, der polarisiertes Licht emittiert.

Bekannt ist, dass eine Schicht aus ausgerichteten elongierten Halbleiter-Nanopartikeln (insbesondere Halbleiter-Nanostäbchen (engl.: "semiconductor nanorods") und Halbleiter-Nanodrähte (engl.: "semiconductor nanowires"), d.h. Nanopartikel mit einem Aspektverhältnis > 1) polarisiertes Licht, entweder durch Photolumineszenz oder alternativ durch Elektrolumineszenz, emittiert. Eine der Herausforderungen, die sich bei der Herstellung von polarisiert emittierenden LEDs, die elongierte Halbleiter-Nanopartikel enthalten, stellt, ist die Realisierung einer möglichst einheitlichen Ausrichtung der Halbleiter-Nanopartikel in der Emitterschicht der LED. Nur wenn die elongierten Nanopartikel in der LED-Emitterschicht möglichst einheitlich ausgerichtet sind, zeigt die LED einen hohen Polarisationsgrad.

R. Hikmet et al., Adv. Mater., 17, 2005, S. 1436-1439, beschreiben die Herstellung einer Leuchtdiode (LED) mit einer Nanostäbchen enthaltenden Emitterschicht. Eine Flüssigkeit, in der die Halbleiter-Nanostäbchen dispergiert sind, wird durch Schleuderbeschichtung auf ein Halbfabrikat der LED aufgebracht. Die Ausrichtung der Halbleiter-Nanostäbchen erfolgt mechanisch durch ein Verreiben der aufgebrachten Flüssigkeit. Nach ihrer Fertigstellung weist die Nanostäbchen-haltige LED einen Polarisationsgrad, bestimmt durch Elektrolumineszenzspektroskopie, von etwa 0,25 auf.

Y. Amit et al., Phys. Status Solidi A, 209, No. 2, 2012, S. 235-242, beschreiben ein Verfahren zur Ausrichtung von Halbleiter-Nanostäbchen durch Verreiben eines durch Rotationsbeschichtung aufgebrachten dünnen Films, in dem die Halbleiter-Nanostäbchen vorliegen.

A. Rizzo et al., ACS Nano, 2009, 3, S. 1506-1512, beschreiben ebenfalls die Herstellung einer Leuchtdiode (LED) mit einer Nanostäbchen enthaltenden Emitterschicht. Die Halbleiter-Nanostäbchen werden auf der Oberfläche einer Flüssigkeit ausgerichtet. Die auf der Flüssigkeitsoberfläche vorliegenden Nanostäbchen werden von einem Stempel aufgenommen und auf ein Halbfabrikat der herzustellenden LED transferiert. Nach ihrer Fertigstellung weist die Nanostäbchen-haltige LED einen Polarisationsgrad, bestimmt durch Elektrolumineszenzspektroskopie, von etwa 0,25 auf.

US 7,700,200 B2 beschreibt eine LED, in deren Emitterschicht Halbleiter-Nanopartikel vorliegen.

US 10,036,921 B2 beschreibt eine Emissionsquelle für polarisiertes Licht, wobei in der Emissionsquelle ausgerichtete Nanostäbchen vorliegen.

US 9,557,573 B2 beschreibt eine Vorrichtung, in der eine Anordnung von Pixeln vorliegt und die Pixel jeweils ausgerichtete Nanostäbchen enthalten.

WO 2015/144288 A1 beschreibt eine Vorrichtung zur Emission von polarisiertem Licht, wobei die Vorrichtung ein Substrat mit Rillen, in denen ausgerichtete Halbleiter-Nanostäbchen vorliegen, aufweist. Zur Herstellung dieser Vorrichtung wird eine Flüssigkeit, in der Halbleiter-Nanostäbchen dispergiert sind, in die Rillen des Substrats eingebracht. Nach dem Verdampfen der Flüssigkeit liegen in den Substratrillen ausgerichtete Nanostäbchen vor.

US 2019/165291 A1 beschreibt eine Leuchtdiode, in deren Emitterschicht ausgerichtete Halbleiter-Nanostäbchen vorliegen. In dem Herstellungsverfahren der Leuchtdiode wird zunächst ein Halbfabrikat der Diode bereit gestellt. Dieses Halbfabrikat enthält zwei Elektroden. Eine Flüssigkeit, in der die Halbleiter-Nanostäbchen dispergiert vorliegen, wird auf das LED-Halbfabrikat aufgebracht. In einem durch die beiden Elektroden generierten elektrischen Feld werden die Nanostäbchen ausgerichtet. Für die Fertigstellung werden noch die beim Betrieb der LED als Anode und Kathode fungierenden Elektroden sowie weitere funktionale Schichten (z.B. Elektronen- und Lochtransportschichten) dem Halbfabrikat hinzugefügt. Die fertige LED weist somit mindestens vier Elektroden auf, wobei nur zwei dieser Elektroden für den Betrieb der LED erforderlich sind und die beiden anderen Elektroden ausschließlich für die Ausrichtung der Halbleiter-Nanostäbchen während des Herstellungsverfahrens verwendet werden. Die Leuchtdiode enthält somit Komponenten, die für den eigentlichen Betrieb der LED nicht erforderlich sind oder den Betrieb unter Umständen sogar nachteilig beeinflussen können und außerdem zu einer unerwünschten Volumenvergrößerung der LED führen.

Eine Aufgabe der vorliegenden Erfindung ist die Herstellung einer Leuchtdiode (LED) über ein effizientes Verfahren. Das Herstellungsverfahren sollte zu einer LED führen, die polarisiertes Licht mit einem hohen Polarisationsgrad emittieren kann, wobei aber der Einbau von Komponenten, die für den Betrieb der LED nicht erforderlich sind, möglichst vermieden werden sollte.

Gelöst wird die Aufgabe durch ein Verfahren zur Herstellung einer polarisiert emittierenden Leuchtdiode, umfassend

- Aufbringen einer Flüssigkeit, in der elongierte Halbleiter-Nanopartikel dispergiert sind, auf eine Oberfläche eines Substrats, das mindestens zwei Elektroden enthält, und Ausrichten der auf der Oberfläche des Substrats aufgebrachten elongierten Halbleiter-Nanopartikel in einem durch die Elektroden erzeugten elektrischen Feld,

- Transferieren der ausgerichteten elongierten Halbleiter-Nanopartikel von der Oberfläche des Substrats auf eine Oberfläche eines Halbfabrikats der Leuchtdiode, wobei das Halbfabrikat eine oder mehrere der folgenden Komponenten enthält: eine Elektronentransportschicht, eine Lochtransportschicht, eine Elektroneninjektionsschicht, eine Lochinjektionsschicht, eine Kathode, eine Anode,

- Fertigstellung der Leuchtdiode durch Anbringen einer oder mehrerer Komponenten auf dem die elongierten Halbleiter-Nanopartikel enthaltenden Halbfabrikat der Leuchtdiode.

Im Rahmen der vorliegenden Erfindung erfolgt die Ausrichtung der elongierten Halbleiter-Nanopartikel in einem elektrischen Feld auf einem externen (d.h. nicht in die finale LED eingebauten) Ausrichtersubstrat. Nach ihrer Ausrichtung im elektrischen Feld werden die elongierten Nanopartikel in einem Transferschritt von der Oberfläche des externen Substrats entfernt und auf eine Oberfläche eines LED-Halbfabrikats übertragen. Wie nachfolgend noch eingehender beschrieben wird, können die ausgerichteten Nanopartikel von der Oberfläche des Substrats zunächst auf eine Oberfläche eines Zwischenträgers und von diesem Zwischenträger auf eine Oberfläche des LED-Halbfabrikats übertragen werden (indirekter Transfer) oder alternativ direkt von der Oberfläche des Substrats auf eine Oberfläche des LED-Halbfabrikats übertragen werden. Nach dem Anbringen der noch fehlenden Komponenten auf dem LED-Halbfabrikat wird die betriebsfähige LED erhalten. Es hat sich überraschend gezeigt, dass sich die auf dem externen Substrat im elektrischen Feld ausgerichteten Nanopartikel mit üblichen Transfermethoden (wie z.B. einem Thermal-Release-Tape oder einem Stempel) unter Beibehaltung der einheitlichen Ausrichtung sehr effizient in das LED-Halbfabrikat transferieren lassen. Ein Einbau von Komponenten, die für den Betrieb der LED nicht erforderlich sind, wird in dem erfindungsgemäßen Verfahren vermieden. Mit dem erfindungsgemäßen Verfahren wird eine LED erhalten, die polarisiertes Licht mit einem sehr hohen Polarisationsgrad emittieren kann. Das emittierte polarisierte Licht ist beispielsweise ein linear polarisiertes Licht.

Die elongierten Halbleiter-Nanopartikel sind insbesondere Halbleiter-Nanostäbchen oder Halbleiter-Nanodrähte.

Geeignete Halbleiter-Nanostäbchen oder -Nanodrähte für Leuchtdioden sind dem Fachmann bekannt.

Die Halbleiter-Nanopartikel enthalten beispielsweise einen oder mehrere Verbindungshalbleiter und/oder einen oder mehrere Elementhalbleiter.

Der Verbindungshalbleiter ist beispielsweise ein II-VI-Halbleiter, ein III-V-Halbleiter, ein I-III-VI-Halbleiter, ein IV-VI-Halbleiter oder ein Perowskit.

Jeder der II-VI-, III-V-, und IV-VI-Verbindungshalbleiter kann eine binäre oder alternativ auch eine ternäre oder quaternäre Verbindung sein.

Hinsichtlich des II-VI-Halbleiters können beispielhaft folgende Verbindungen genannt werden: CdS, CdSe, CdTe, ZnO, ZnS, ZnSe, ZnTe, (Zn,Cd)S, (Zn,Cd)S, (Zn,Cd)Se, (Zn,Cd)Te, Cd(S,Se), Cd(Se,Te), Zn(S,Se), Zn(Se,Te), HgS, HgSe, HgTe, (Hg,Cd)Te.

Hinsichtlich des III-V-Halbleiters können beispielhaft folgende Verbindungen genannt werden: InP, InSb, InAs, GaP, GaAs, GaSb, GaN, AlN, InN, (Al,Ga)As, (In,Ga)N.

Hinsichtlich des I-III-VI-Halbleiters können beispielhaft folgende Verbindungen genannt werden: $CuInSe_2$, $CuInS_2$.

Hinsichtlich des IV-VI-Halbleiters können beispielhaft folgende Verbindungen genannt werden: PbS, PbSe, PbTe, SnS, SnSe, SnTe.

Als Elementhalbleiter kann beispielsweise Si, Ge oder Kohlenstoff (z.B. in Form von "Carbon Nanorods") genannt werden.

Die Halbleiter-Nanopartikel können beispielsweise nur eines der oben genannten Halbleitermaterialien enthalten. Zur gezielten Einstellung der optoelektronischen Eigenschaften kann es alternativ bevorzugt sein, dass die Halbleiter-Nanopartikel eine Heterostruktur aufweisen, in der ein erstes Halbleitermaterial (z.B. eine erste Halbleiterverbindung) und ein zweites Halbleitermaterial (z.B. eine zweite Halbleiterverbindung) vorliegen. Beispielsweise ist ein erstes Halbleitermaterial zumindest teilweise von einem zweiten Halbleitermaterial umschlossen (z.B. in Form einer Stab-in-Stab- oder eine Punkt-in-Stab-Heterostruktur). Beispielsweise befindet sich an den beiden Enden eines elongierten Nanopartikels ein erstes Halbleitermaterial und in dem dazwischen liegenden Bereich des elongierten Nanopartikels liegt ein zweites Halbleitermaterial vor (z.B. hantelförmige Halbleiter-Nanostäbchen). Solche Heterostrukturen für Halbleiter-Nanostäbchen oder - Nanodrähte sind dem Fachmann bekannt, siehe z.B. U. Banin et al., Angew. Chem., 2018, 130, S. 4354-4376. Liegen die Halbleiter-Nanopartikel als Heterostruktur vor, bei der ein erstes Halbleitermaterial zumindest teilweise von einem zweiten Halbleitermaterial umschlossen ist, kann es bevorzugt sein, dass das zweite Halbleitermaterial im Vergleich zum ersten Halbleitermaterial eine größere Bandlücke aufweist.

Die elongierten Halbleiter-Nanopartikel weisen beispielsweise eine Breite im Bereich von 1 nm bis 50 nm, bevorzugter 2 nm bis 30 nm auf. Das Aspektverhältnis (d.h. das Verhältnis von Länge zu Breite) der elongierten Halbleiter-Nanopartikel beträgt bevorzugt mindestens 1,25. Für die Bestimmung des Aspektverhältnisses eines elongierten Nanopartikels wird die Breite an der "dünnsten Stelle" des Nanopartikels herangezogen. Die Halbleiter-Nanostäbchen weisen beispielsweise eine Länge ≤ 200 nm, z.B. im Bereich von 5 nm bis 200 nm auf. Nanodrähte weisen im Vergleich zu Nanostäbchen eine größere Länge, die sogar im μm-Bereich (z.B. bis zu 10 μm) liegen kann, auf. Länge und Breite der Nanostäbchen werden mittels Elektronenmikroskopie (z.B. Raster- oder Transmissionselektronen-mikroskopie) bestimmt.

Aufgrund der länglichen Form weist das von einem einzelnen elongierten Halbleiter-Nanopartikel emittierte Licht beispielsweise einen Polarisationsgrad, bestimmt durch polarisationsabhängige Spektroskopie, von mindestens 0,3 auf.

Elongierte Halbleiter-Nanopartikel sind kommerziell erhältlich oder lassen sich über Verfahren, die dem Fachmann bekannt sind, herstellen. Die Synthese kann beispielsweise in einer organischen (bevorzugt hochsiedenden) oder wässrigen Flüssigkeit oder auch über eine Gasphasenreaktion erfolgen. Informationen über die Herstellung von Halbleiter-Nanostäbchen und -Nanodrähten finden sich beispielsweise in folgenden Publikationen:

- U. Banin et al., Angew. Chem., 2018, 130, S. 4354-4376;
- P. Yang et al., Adv. Mater., 2014, 26, S. 2137-2184.

Um die Dispergierbarkeit der Halbleiter-Nanopartikel in der Flüssigkeit zu verbessern, können auf der Oberfläche der Nanostäbchen optional organische Verbindungen bzw. Liganden vorliegen. Dies ist dem Fachmann bekannt.

Die Flüssigkeit, in der die Halbleiter-Nanopartikel dispergiert sind, enthält beispielsweise eine organische Verbindung. Bevorzugt ist die organische Verbindung eine bei 25°C flüssige Verbindung. Bei der organischen Verbindung kann es sich beispielsweise um einen aliphatischen Kohlenwasserstoff, z.B. ein Alkan (z.B. ein $C_{5-12}$-Alkan, bevorzugter ein $C_{6-10}$-Alkan) oder ein Alken; eine aromatische Verbindung (z.B. Toluol); eine halogenierte Verbindung; einen Alkohol; ein Amin; einen Ether oder einen Ester oder ein Gemisch aus mindestens zwei dieser Verbindungen handeln. Sofern die Flüssigkeit, in der die Nanopartikel dispergiert sind, eine polare organische Verbindung enthält, kann optional auch Wasser anwesend sein. Bevorzugt enthält die Flüssigkeit, in der die Nanopartikel dispergiert sind, weniger als 5 Vol% Wasser. Noch bevorzugter ist die Flüssigkeit wasserfrei.

Bei der Flüssigkeit, in der Nanopartikel dispergiert sind, kann es sich auch um eine Schmelze (z.B. ein geschmolzenes Polymer) handeln.

Die Flüssigkeit, in der die Halbleiter-Nanostäbchen dispergiert sind, wird auf einer Oberfläche eines Substrats aufgebracht. Wie nachfolgend noch eingehender beschrieben wird, enthält das Substrat mindestens zwei Elektroden, die für das Ausrichten der Nanostäbchen genutzt werden.

Das Aufbringen der Flüssigkeit auf der Substratoberfläche erfolgt durch Verfahren, die dem Fachmann bekannt sind. Beispielsweise wird die Flüssigkeit, in der die elongierten Halbleiter-Nanopartikel dispergiert sind, durch eine Tauchbeschichtung, eine Schleuderbeschichtung, eine Sprühbeschichtung oder eine Tropfbeschichtung ("drop coating") aufgebracht.

Das Substrat ist beispielsweise ein Kunststoffsubstrat, ein Glassubstrat, ein oxidierter Siliziumwafer oder ein Keramiksubstrat. Es können aber auch andere Materialien, die geeignet sind, die Elektroden elektrisch voneinander zu isolieren, verwendet werden.

Die Elektroden des Substrats sind bevorzugt so angeordnet, dass nach Anlegen einer Spannung und Ausbildung eines elektrischen Feldes ein möglichst hoher Anteil des Feldes parallel zu der Substratoberfläche, auf der die Nanostäbchen-haltige Flüssigkeit aufgebracht wird, verläuft. Hierfür geeignete Elektroden und relative Anordnungen der Elektroden zueinander sind dem Fachmann bekannt.

Beispielsweise ist zumindest eine der Elektroden eine verzweigte Elektrode (d.h. eine Elektrode, die Verzweigungen aufweist). Optional können auch beide Elektroden verzweigt sein. Beispielsweise weist die verzweigte Elektrode einen Steg auf, von dem zwei oder mehr Finger abzweigen (nachfolgend auch als Kammelektrode bezeichnet). Eine geeignete Breite der Finger und geeignete Abstände zwischen den Fingern lassen sich durch Routineversuche bestimmen.

In einer bevorzugten Ausführungsform sind die Elektroden so angeordnet, dass eine interdigitierte Elektrodenstruktur vorliegt (z.B. zwei Kammelektroden, mit ineinandergreifenden Fingern). Alternativ können die Elektroden übereinander liegend angeordnet sein. Die Elektroden sind so angeordnet, dass sie sich nicht berühren. Sind die zwei Elektroden übereinanderliegend angeordnet, kann beispielsweise eine erste Elektrode auf der Oberfläche des Substrats vorliegen, während die unterhalb der ersten Elektrode liegende zweite Elektrode in das Substrat eingebettet ist; oder es können beispielsweise beide Elektroden in das Substrat eingebettet sein.

Beispielsweise liegen die Elektroden (z.B. in Form einer interdigitierten Elektrodenstruktur) auf der Oberfläche des Substrats vor. In diesem Fall kommen die Elektroden mit der aufgebrachten Nanopartikel-haltigen Flüssigkeit in Berührung.

Alternativ ist es auch möglich, dass eine Elektrode auf der Substratoberfläche vorliegt und daher mit der Nanopartikel-haltigen Flüssigkeit in Kontakt kommt, während die zweite Elektrode in das Substrat eingebettet ist und daher mit der Flüssigkeit nicht in Kontakt kommt. Die auf der Substratoberfläche vorliegende Elektrode weist bevorzugt eine verzweigte (z.B. kammartige) Struktur auf. Die eingebettete Elektrode kann beispielsweise plattenförmig oder verzweigt sein.

Gemäß einer weiteren beispielhaften Ausführungsform sind die Elektroden in das Substrat eingebettet. Bevorzugt sind die Elektroden vollständig in das Substrat eingebettet, d.h. die Elektroden liegen unterhalb der Substratoberfläche und kommen mit der auf die Substratoberfläche aufgebrachten Nanopartikel-haltigen Flüssigkeit nicht in Kontakt. Es ist allerdings auch möglich, dass die eingebetteten Elektroden planar mit der Substratoberfläche abschießen. Die Verwendung eingebetteter Elektroden eröffnet die Möglichkeit, die Oberfläche des Substrats, auf der die Nanopartikel enthaltende Flüssigkeit aufgebracht wird, als planare Oberfläche zu gestalten. Wie nachfolgend noch beschrieben wird, kann dies vorteilhaft sein, wenn die elongierten Halbleiter-Nanopartikel nach ihrer Ausrichtung im elektrischen Feld direkt von der Oberfläche des Substrats auf ein Halbfabrikat der Leuchtdiode transferiert werden (d.h. wenn der Transfer erfolgt, indem die Substratoberfläche, auf der die ausgerichteten Nanopartikel vorliegen, mit einer Oberfläche des LED-Halbfabrikats kontaktiert wird und dabei die Nanopartikel auf das LED-Halbfabrikat transferiert werden). Die in das Substrat eingebetteten Elektroden können beispielsweise jeweils eine verzweigte (z.B. kammartige) Struktur aufweisen und so zueinander angeordnet sein, dass eine interdigitierte Elektrodenstruktur vorliegt. Alternativ ist es auch möglich, dass die eingebetteten Elektroden als eine obere Elektrode und eine untere Elektrode vorliegen, wobei die obere Elektrode gegenüber der unteren Elektrode näher an der Substratoberfläche liegt. Die obere, d.h. näher zur Substratoberfläche vorliegende Elektrode ist beispielsweise eine verzweigte (z.B. kammartige) Elektrode und die untere Elektrode ist beispielsweise eine plattenförmige oder ebenfalls eine verzweigte (z.B. kammartige) Elektrode.

Geeignete Materialien für die Ausbildung von Elektroden sind dem Fachmann bekannt. Beispielsweise enthalten die Elektroden des Substrats ein Edelmetall (z.B. Platin, Palladium, Gold oder Silber), Kupfer, Titan, Aluminium, Indiumzinnoxid, Fluor-dotiertes Zinnoxid ("FTO") oder Kohlenstoff (z.B. Graphit, Graphen, Kohlenstoffnanoröhren, Kohlenstoffnanopartikel).

Durch Anlegen einer elektrischen Spannung an die Elektroden wird ein elektrisches Feld zwischen den Elektroden generiert. In diesem elektrischen Feld richten sich die elongierten Halbleiter-Nanopartikel aus.

Das elektrische Feld kann ein elektrisches Wechselfeld (generiert durch eine Wechselspannung) oder ein elektrisches Gleichfeld (generiert durch eine Gleichspannung) sein.

Das elektrische Feld wird solange aufrecht erhalten, bis eine ausreichend gleichförmige Ausrichtung der elongierten Halbleiter-Nanopartikel vorliegt. Beispielsweise wird das elektrische Feld solange aufrecht erhalten, bis die Flüssigkeit, mit der die Nanopartikel auf die Substratoberfläche aufgebracht wurden, im Wesentlichen vollständig (z.B. zu mindestens 90%, bevorzugter mindestens 95%, bezogen auf das Volumen der Flüssigkeit) verdampft ist. Handelt es sich bei der Flüssigkeit um eine Schmelze, wird der geschmolzene Zustand solange aufrecht erhalten, bis eine ausreichend gleichförmige Ausrichtung der Halbleiter-Nanopartikel vorliegt.

Geeignete Feldstärken für die Ausrichtung der elongierten Halbleiter-Nanopartikel auf der Oberfläche des Substrats kann der Fachmann durch Routineversuche bestimmen.

Die Ausrichtung der Nanopartikel im elektrischen Feld kann gegebenenfalls durch Aufnahme von Photolumineszenzspektren und dem aus diesen Spektren bestimmten Polarisationsgrad überprüft werden.

Die ausgerichteten Halbleiter-Nanopartikel werden von der Oberfläche des Substrats auf ein Halbfabrikat der Leuchtdiode transferiert.

Bei dem Transfer werden die ausgerichteten Halbleiter-Nanopartikel von der Oberfläche des Substrats entfernt und auf eine Oberfläches des LED-Halbfabrikats übertragen.

Der Transfer kann ein indirekter Transfer oder ein direkter Transfer sein. Bei dem indirekten Transfer werden die durch das elektrische Feld ausgerichteten elongierten Halbleiter-Nanopartikel von der Oberfläche des Substrats auf eine Oberfläche eines Zwischenträgers übertragen und anschließend von der Oberfläche des Zwischenträgers auf eine Oberfläche des LED-Halbfabrikats übertragen. Bei dem direkten Transfer werden die durch das elektrische Feld ausgerichteten elongierten Halbleiter-Nanopartikel von der Oberfläche des Substrats direkt (d.h. ohne Verwendung eines Zwischenträgers) auf eine Oberfläche des LED-Halbfabrikats übertragen.

Die Variante des indirekten Transfers umfasst üblicherweise folgende Schritte:

(i) Eine Oberfläche des Zwischenträgers wird mit den auf der Substratoberfläche vorliegenden und ausgerichteten Halbleiter-Nanopartikeln in Kontakt gebracht,

(ii) der Zwischenträger wird von dem Substrat entfernt, wobei die Halbleiter-Nanopartikel zumindest teilweise auf der Oberfläche des Zwischenträgers verbleiben,

(iii) die Oberfläche des Zwischenträgers, auf der die Nanopartikel vorliegen, wird mit einer Oberfläche des LED-Halbfabrikats in Kontakt gebracht,

(iv) der Zwischenträger wird von dem LED-Halbfabrikat entfernt, wobei die Halbleiter-Nanopartikel zumindest teilweise auf der Oberfläche des LED-Halbfabrikats verbleiben.

Geeignete Zwischenträger für den indirekten Transfer sind dem Fachmann bekannt. Beispielsweise ist der Zwischenträger ein Stempel, ein wärmelösbares Klebeband (auch als "Thermal Release Tape" bezeichnet) oder ein Polymerfilm.

Die Kontaktfläche des Stempels ist beispielsweise aus einem Elastomer, z.B. einem Polysiloxan wie PDMS, gefertigt (Elastomerstempel). Solche Stempel für den Transfer eines Materials von einer ersten Oberfläche auf eine Zieloberfläche sind dem Fachmann bekannt.

Durch Variation des Anpressdrucks, der Temperatur und/odes des Winkels, unter dem der Transfer durchgeführt wird, kann der Transferschritt optimiert weden. Geeignete Parameter kann der Fachmann durch Routineversuche bestimmen.

Ein wärmelösbares Klebeband zeigt bei Raumtemperatur eine starke Haftung und kann nach erfolgtem Transfer durch Erwärmen wieder abgelöst werden. Solche wärmelösbaren Klebebänder sind kommerziell erhältlich.

Der indirekte Transfer kann beispielsweise auch erfolgen, indem auf den ausgerichteten Nanopartikeln, die auf der Substratoberfläche vorliegen, ein Polymerfilm (z.B. ein Film eines Polyacrylats, Polymethylacrylats oder Polymethylmethacrylats oder ein Film eines natürlichen Polymers wie Cellulose oder Celluloseacetat) ausgebildet wird, der Polymerfilm mit den anhaftenden Nanopartikeln von der Substratoberfläche entfernt und anschließend mit einer Oberfläche des LED-Halbfabrikats in Kontakt gebracht wird, und die Nanopartikel beim Entfernen des Polymerfilms auf der Oberfläche des LED-Halbfabrikat verbleiben.

Bei dem direkten Transfer wird beispielsweise die Oberfläche des Substrats, auf der die ausgerichteten Nanopartikel vorliegen, mit einer Oberfläche des LED-Halbfabrikats in Kontakt gebracht und anschließend wird das Substrat von dem LED-Halbfabrikat entfernt, wobei die Halbleiter-Nanopartikel zumindest teilweise auf der Oberfläche des LED-Halbfabrikats verbleiben. Durch Variation des Anpressdrucks, der Temperatur und/odes des Winkels, unter dem der Transfer durchgeführt wird, kann der Transferschritt optimiert weden. Geeignete Parameter kann der Fachmann durch Routineversuche bestimmen. Beim direkten Transfer der ausgerichteten Nanopartikel von der Substratoberfläche auf eine Oberfläche des LED-Halbfabrikats wird ein Zwischenträger nicht benötigt.

Gemäß einer weiteren beispielhaften Variante des direkten Transfers werden auf den auf der Oberfläche des Substrats vorliegenden und ausgerichteten Halbleiter-Nanopartikeln mehrere Schichten aufgebracht, wobei diese Schichten das Halbfabrikat der Leuchtdiode bilden, und anschließend wird das Substrat von dem LED-Halbfabrikat entfernt, wobei die ausgerichteten Halbleiter-Nanopartikel zumindest teilweise auf der Oberfläche des Halbfabrikats der Leuchtdiode verbleiben.

Unter einem Halbfabrikat einer LED ist ein Bauelement zu verstehen, das zwar schon Komponenten der LED enthält, dem aber noch eine oder mehrere Komponenten hinzuzufügen sind, um eine betriebsbereite LED zu erhalten.

Das LED-Halbfabrikat enthält eine oder mehrere der folgenden LED-Komponenten: Eine Elektronentransportschicht ("Electron Transport Layer", ETL), eine Lochtransportschicht ("Hole Transport Layer", HTL), eine Elektroneninjektionsschicht ("Electron Injection Layer", EIL), eine Lochinjektionsschicht ("Hole Injection Layer", HIL), eine Kathode, eine Anode.

Geeignete Materialien für diese Komponenten einer Leuchtdiode sind dem Fachmann bekannt. Beispielsweise kann auf die in US 2019/165291 A1 (Absätze [0083]-[0088]) genannten Materialien verwiesen werden.

Die Lochtransportschicht und oder die Lochinjektionsschicht kann beispielsweise eine oder mehrere der folgenden Verbindungen enthalten: Poly(3,4-ethylendioxythiophen)polystyrolsulfonat (PEDOT/PSS), Polythiophen, Polyaniline, Tri-[4-(5-phenyl-2-thienyl)phenyl]amin, 4,4',4"-Tri[2-naphthyl(phenylamino]triphenylamine (2-TNATA), 4,4',4"-Tri-(3-methylphenylanilino)triphenylamin (m-MTDATA), Cu-Phthalocyanin (CuPc), N,N'-Diphenyl-N,N'-bis(3-methylphenyl)-1,1'-diphenyl-4,4'-diamin (TPD), ein Molybdenoxid, ein Vanadiumoxid, ein Wolframoxid, ein Chromoxid, ein Molybdensulfid, ein Wolframsulfid, ein Molybdenselenid, ein Wolframselenid, ein Graphenoxid, ein Polyvinylcarbazol oder ein Polytriphenylamin.

Die Elektronentransportschicht enthält beispielsweise ein anorganisches Oxid, z.B. ein Zinkoxid, ein Titanoxid, ein Zinnoxid, ein Zirkonoxid, ein Tantaloxid, ein Al-Zn-Oxid, ein Zn-Sn-Oxid oder ein In-Sn-Oxid, oder eine organische Verbindung wie z.B. Aluminium-tris(8-hydroxychinolin).

Die Elektroneninjektionsschicht enthält beispielsweise eine oder mehrere der folgenden Verbindungen: LiF, Lithium-(8-hydroxychinolin), ein Alkalimetalloxid (z.B. ein Lithiumoxid oder ein Lithiumboroxid), ein Alkalimetallsilikat, ein Alkalimetallcarbonat, ein Alkalimetallfluorid.

Beispielsweise liegen die transferierten Halbleiter-Nanopartikel auf der Elektronentransportschicht ("Electron Transport Layer", ETL) oder der Lochtransportschicht ("Hole Transport Layer", HTL) des LED-Halbfabrikats vor.

Die in das LED-Halbfabrikat transferierten ausgerichteten Halbleiter-Nanopartikel fungieren in der finalen LED als elektrolumineszierende Emitterschicht, die polarisiertes Licht emittiert. Aufgrund der sehr gleichförmigen Ausrichtung der elongierten Nanopartikel weist das emittierte polarisierte Licht einen sehr hohen Polarisationsgrad auf.

Nach dem Transfer der Halbleiter-Nanopartikel werden dem Nanopartikel-haltigen Halbfabrikat noch die fehlenden LED-Komponenten hinzugefügt.

Die noch hinzuzufügenden Komponenten können beispielsweise eine oder mehrere der folgenden Komponenten sein, sofern diese nicht schon in dem LED-Halbfabrikat vor dem Nanopartikel-Transfer vorlagen: Eine Elektronentransportschicht ("Electron Transport Layer", ETL), eine Lochtransportschicht ("Hole Transport Layer", HTL), eine Elektroneninjektionsschicht ("Electron Injection Layer", EIL), eine Lochinjektionsschicht ("Hole Injection Layer", HIL), eine Kathode, eine Anode.

Da die elongierten Halbleiter-Nanopartikel nach ihrer Ausrichtung im elektrischen Feld auf der Oberfläche des Substrats von dieser Substratoberfläche auf eine Oberfläche eines LED-Halbfabrikats transferiert wurden, wird durch das erfindungsgemäße Verfahren eine LED erhalten, in der das Ausrichtersubstrat nicht mehr vorliegt.

In einer beispielhaften Ausführungsform enthält das LED-Halbfabrikat zumindest eine Lochtransportschicht und eine Anode und optional eine Lochinjektionsschicht, die transferierten Halbleiter-Nanopartikel liegen auf der Lochtransportschicht vor und die nach dem Transfer noch hinzuzufügenden Komponenten umfassen zumindest eine Elektronentransportschicht und eine Kathode und optional eine Elektroneninjektionsschicht. In einer weiteren beispielhaften Ausführungsform enthält das LED-Halbfabrikat zumindest eine Elektronentransportschicht und eine Kathode und optional eine Elektroneninjektionsschicht, die transferierten Halbleiter-Nanopartikel liegen auf der Elektronentransportschicht vor und die nach dem Transfer noch hinzuzufügenden Komponenten umfassen zumindest eine Lochtransportschicht und eine Anode und optional eine Lochinjektionsschicht.

Mit dem Verfahren der vorliegenden Erfindung ist beispielsweise eine Leuchtdiode erhältlich, die eine Emitterschicht enthält, in der elongierte Halbleiter-Nanopartikel vorliegen, wobei das von den elongierten Halbleiter-Nanopartikeln durch Elektrolumineszenz emittierte Licht einen Polarisationsgrad, bestimmt durch polarisationsabhängige Spektroskopie, von mindestens 0,35 aufweist.

Bevorzugt ist das polarisierte Licht ein linear polarisiertes Licht.

Der Polarisationsgrad PG ergibt sich aus der folgenden Beziehung:

$$PG = (I_{\parallel} - I_{\perp})/(I_{\parallel} + I_{\perp})$$

wobei

$I_{\parallel}$: Gesamtintensität der Elektrolumineszenz der elongierten Halbleiter-Nanopartikel in der Emitterschicht, aufgenommen in paralleler Polarisationsrichtung,

$I_{\perp}$: Gesamtintensität der Elektrolumineszenz der elongierten Halbleiter-Nanopartikel in der Emitterschicht, aufgenommen in orthogonaler Polarisationsrichtung.

Die Elektrolumineszenzspektren werden bei 25°C aufgenommen. Die Intensität der Peaks wird anhand der Peakfläche bestimmt.

Beispielsweise beträgt der Polarisationsgrad 0,35-0,80.

Die vorliegende Erfindung wird anhand des nachfolgenden Beispiels eingehender beschrieben.

**Beispiel**

Eine Dispersion von Halbleiter-Nanostäbchen wurde durch Drop-Coating auf ein Elektroden enthaltendes Substrat aufgebracht. Bei den Halbleiter-Nanostäbchen handelte es sich um CdSe/CdS-Dot-in-Rod-Partikel. Die Nanopartikel wurden erzeugt, indem eine elongierte CdS-Struktur auf CdSe-Nanopartikel aufgewachsen wurde. Die Halbleiter-Nanostäbchen wiesen eine Länge von (30+/-5) nm und einen Durchmesser von (4.4+/-0.8) nm auf. Bei dem Substrat handelte es sich um ein Glassubstrat.

Beide Elektroden (Au/Ti) waren kammförmig und auf der Oberfläche des Substrats so zueinander angeordnet, dass eine interdigitierte Elektrodenstruktur vorlag. Die Höhe der Elektroden betrug etwa 50 nm (ca. 40 nm Au auf ca. 10 nm Ti Haftschicht).

Nach dem Aufbringen waren die Elektroden zunächst vollständig von der Flüssigkeit bedeckt. An die Elektroden wurde ein elektrisches Wechselfeld angelegt (Amplitude: 5-7,5 V/$\mu$m). Nach dem Verdampfen der Flüssigkeit wurde das Feld entfernt.

Durch das Anlegen des elektrischen Feldes richteten sich die Halbleiter-Nanostäbchen auf dem Substrat aus.

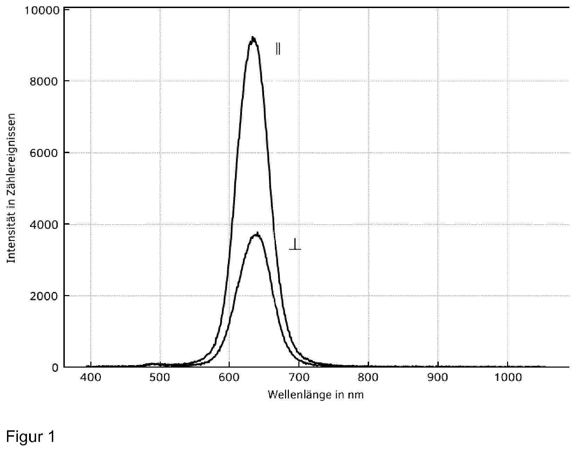

Figur 1 zeigt Photoemissionsspektren von Halbleiter-Nanostäbchen, die durch das Anlegen eines elektrischen Feldes an die Elektroden auf dem Substrat ausgerichtet wurden. Die Spektren wurden unter Anregung mit blauem Licht (~450 nm) in paralleler sowie orthogonaler Polarisationsrichtung aufgenommen. Aus den Photoemissionsspektren konnte ein Polarisationsgrad PG von 0,4 ermittelt werden.

Unter Verwendung eines als Zwischenträger fungierenden wärmelösbaren Klebebands wurde eine Schicht der ausgerichteten Halbleiter-Nanostäbchen von der Oberfläche des Substrats entnommen.

Im Anschluss wurde die von dem Ausrichtersubstrat entnommene Nanopartikelschicht auf die Oberfläche eines LED-Halbfabrikats transferiert. Hierfür wurde die am wärmelösbaren Klebenband anhaftende Schicht der Halbleiter-Nanostäbchen mit der oberen Schicht des LED-Halbfabrikats in Kontakt gebracht. Durch Erhitzen auf 150 °C löste sich die Nanopartikelschicht vom wärmelösbaren Klebeband und das Band wurde entfernt. Bei der oberen Schicht des LED-Halbfabrikats handelte es sich um eine Lochtransportschicht (HTL), die Polyvinylcarbazol enthielt. Das LED-Halbfabrikat enthielt außerdem eine auf einem Glassubstrat vorliegende Indiumzinnoxid-Elektrode und eine Lochinjektionsschicht (HIL). Die Lochinjektionsschicht enthielt Poly(3,4-ethylendioxythiophen)polystyrensulfonat (PEDOT:PSS).

Nach erfolgtem Transfer der Nanostäbchen wurden noch die fehlenden Komponenten zur Fertigstellung einer betriebsbereiten LED hinzugefügt. Hierfür wurden ZnO-Nanopartikel als Elektronentransportschicht und eine Aluminiumkathode (Dicke ca. 200 nm) auf das die ausgerichteten Nanostäbchen enthaltende LED-Halbfabrikat aufgebracht.

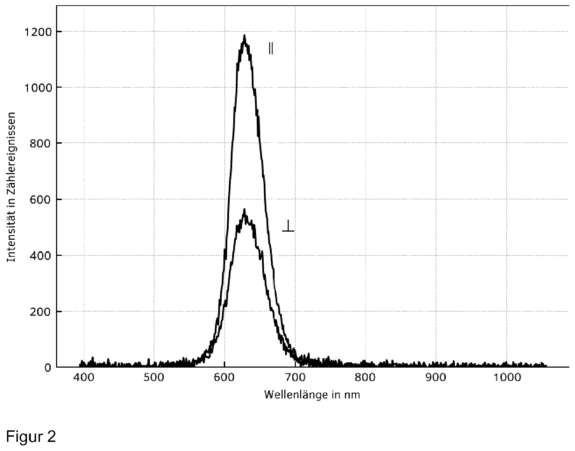

In der finalen LED fungieren die ausgerichteten Halbleiter-Nanostäbchen als Emitterschicht. Für die Bestimmung des Polarisationsgrades wurden die Gesamtintensität der Elektrolumineszenz der elongierten Halbleiter-Nanopartikel in der Emitterschicht, aufgenommen in paralleler Polarisationsrichtung, und die Gesamtintensität der Elektrolumineszenz der elongierten Halbleiter-Nanopartikel in der Emitterschicht, aufgenommen in orthogonaler Polarisationsrichtung, gemessen. Der Polarisationsgrad PG = $(I_\parallel - I_\perp)/(I_\parallel + I_\perp)$ betrug 0,4. Die gemessenen Spektren zeigt Figur 2. Mit dem erfindungsgemäßen Verfahren wird also eine LED erhalten, die im Betrieb einen sehr hohen Polarisationsgrad aufweist. Da die elongierten Halbleiter-Nanopartikel nach ihrer Ausrichtung im elektrischen Feld auf der Oberfläche des Substrats von dieser Substratoberfläche auf eine Oberfläche eines LED-Halbfabrikats transferiert wurden, wird durch das erfindungsgemäße Verfahren eine LED erhalten, in der das Ausrichtersubstrat nicht mehr vorliegt. Der Einbau einer für den Betrieb der LED nicht erfoderlichen Komponente wird also vermieden.

**Patentansprüche**

1. Verfahren zur Herstellung einer polarisiert emittierenden Leuchtdiode, umfassend

   - Aufbringen einer Flüssigkeit, in der elongierte Halbleiter-Nanopartikel dispergiert sind, auf eine Oberfläche eines Substrats, das mindestens zwei Elektroden enthält, und Ausrichten der auf der Oberfläche des Substrats aufgebrachten elongierten Halbleiter-Nanopartikel in einem durch die Elektroden erzeugten elektrischen Feld,
   - Transferieren der ausgerichteten elongierten Halbleiter-Nanopartikel von der Oberfläche des Substrats auf eine Oberfläche eines Halbfabrikats der Leuchtdiode, wobei das Halbfabrikat eine oder mehrere der folgenden Komponenten enthält: eine Elektronentransportschicht, eine Lochtransportschicht, eine Elektroneninjektionsschicht, eine Lochinjektionsschicht, eine Kathode, eine Anode,
   - Fertigstellung der Leuchtdiode durch Anbringen einer oder mehrerer Komponenten auf dem die elongierten Halbleiter-Nanopartikel enthaltenden Halbfabrikat der Leuchtdiode.

2. Verfahren nach Anspruch 1, wobei die elongierten Halbleiter-Nanopartikel Halbleiter-Nanostäbchen oder Halbleiter-Nanodrähte sind.

3. Verfahren nach Anspruch 1 oder 2, wobei die Elektroden auf der Oberfläche des Substrats vorliegen.

4. Verfahren nach Anspruch 1 oder 2, wobei mindestens eine der Elektroden in das Substrat eingebettet ist.

5. Verfahren nach einem der vorstehenden Ansprüche, wobei die Elektroden verzweigt sind und eine interdigitierte Elektrodenanordnung bilden.

6. Verfahren nach einem der Ansprüche 1, 2 oder 4, wobei die Elektroden übereinander liegend angeordnet sind.

7. Verfahren nach einem der vorstehenden Ansprüche, wobei das elektrische Feld ein elektrisches Wechselfeld ist.

8. Verfahren nach einem der vorstehenden Ansprüche, wobei der Transfer umfasst, dass die ausgerichteten elongierten Halbleiter-Nanopartikel von der Oberfläche des Substrats auf eine Oberfläche eines Zwischenträgers und anschließend von der Oberfläche des Zwischenträgers auf die Oberfläche des Halbfabrikats der Leuchtdiode übertragen werden.

9. Verfahren nach Anspruch 8, wobei der Zwischenträger ein Stempel, ein wärmelösbares Klebeband oder ein Polymerfilm ist.

10. Verfahren nach einem der Ansprüche 1-7, wobei der Transfer umfasst, dass die Oberfläche des Substrats, auf der die ausgerichteten elongierten Halbleiter-Nanopartikel vorliegen, mit der Oberfläche des Halbfabrikats der Leuchtdiode in Kontakt gebracht wird und anschließend das Substrat von dem Halbfabrikat der Leuchtdiode entfernt wird, wobei die elongierten Halbleiter-Nanopartikel zumindest teilweise auf der Oberfläche des Halbfabrikats der Leuchtdiode verbleiben.

11. Verfahren nach einem der Ansprüche 1-7, wobei der Transfer umfasst, dass auf den auf der Oberfläche des Substrats vorliegenden und ausgerichteten elongierten Halbleiter-Nanopartikel mehrere Schichten aufgebracht werden, wobei diese Schichten das Halbfabrikat der Leuchtdiode bilden, und anschließend das Substrat von dem Halbfabrikat der Leuchtdiode entfernt wird, wobei die elongierten Halbleiter-Nanopartikel zumindest teilweise auf der Oberfläche des Halbfabrikats der Leuchtdiode verbleiben.

**Claims**

1. Method for producing a light-emitting diode having polarized emission, comprising:

- applying a liquid, in which elongated semiconductor nanoparticles are dispersed, to a surface of a substrate containing at least two electrodes, and aligning the semiconductor nanoparticles applied on the substrate surface in an electric field generated by the electrodes,
- transferring the aligned elongated semiconductor nanoparticles from the surface of the substrate to a surface of a semi-finished product of the light-emitting diode, wherein the semi-finished product includes one or more of the following components: an electron transport layer, a hole transport layer, an electron injection layer, a hole injection layer, a cathode, an anode,
- finishing the light-emitting diode by attaching one or more components to the semi-finished product of the light-emitting diode that contains the elongated semiconductor nanoparticles.

2. Method according to Claim 1, wherein the elongated semiconductor nanoparticles are semiconductor nanorods or semiconductor nanowires.

3. Method according to Claim 1 or 2, wherein the electrodes are present on the surface of the substrate.

4. Method according to Claim 1 or 2, wherein at least one of the electrodes is embedded in the substrate.

5. Method according to any one of the preceding claims, wherein the electrodes are branched and form an interdigitated electrode assembly.

6. Method according to any one of Claims 1, 2 or 4, wherein the electrodes are arranged one above the other.

7. Method according to any one of the preceding claims, wherein the electrical field is an alternating electrical field.

8. Method according to any one of the preceding claims, wherein the transfer comprises that the aligned, elongated semiconductor nanoparticles are transferred from the surface of the substrate to a surface of an intermediate carrier and then from the surface of the intermediate carrier to the surface of the semi-finished product of the light-emitting diode.

9. Method according to Claim 8, wherein the intermediate carrier is a stamp, a heat-releasable adhesive tape or a polymer film.

10. Method according to any one of Claims 1-7, wherein the transfer comprises that the surface of the substrate on which the aligned, elongated semiconductor nanoparticles are present is brought into contact with the surface of the semi-finished product of the light-emitting diode, and then the substrate is removed from the semi-finished product of the light-emitting diode is removed, the elongated semiconductor nanoparticles remaining at least partially on the surface of the semi-finished product of the light-emitting diode.

11. Method according to any one of Claims 1-7, wherein the transfer comprises that several layers are applied to the elongated semiconductor nanoparticles that are present and aligned on the surface of the substrate, wherein said layers form the semi-finished product of the light-emitting diode, and the substrate is then removed from the semi-finished product of the light-emitting diode, the elongated semiconductor nanoparticles remaining at least partially on the surface of the semi-finished product of the light-emitting diode.

## Revendications

1. Procédé de fabrication d'une diode électroluminescente à émission polarisée comprenant

    - l'application d'un liquide, dans lequel des nanoparticules semi-conductrices allongées sont dispersées, sur une surface d'un substrat contenant au moins deux électrodes et l'alignement des nanoparticules semi-conductrices allongées appliquées sur la surface du substrat dans un champ électrique généré par les électrodes,
    - le transfert des nanoparticules semi-conductrices allongées alignées de la surface du substrat sur une surface d'un demi-produit de la diode électroluminescente, dans lequel le demi-produit contient un ou plusieurs des composants suivants : une couche de transport d'électrons, une couche de transport de trous, une couche d'injection d'électrons, une couche d'injection de trous, une cathode, une anode,
    - l'achèvement de la diode électroluminescente par la mise en place d'un ou plusieurs composants sur le demi-produit de la diode électroluminescente contenant les nanoparticules semi-conductrices allongées.

2. Procédé selon la revendication 1, dans lequel les nanoparticules semi-conductrices allongées sont des nanobarres semi-conductrices ou des nanofils semiconducteurs.

3. Procédé selon la revendication 1 ou 2, dans lequel les électrodes sont présentes sur la surface du substrat.

4. Procédé selon la revendication 1 ou 2, dans lequel au moins une des électrodes est intégrée dans le substrat.

5. Procédé selon l'une des revendications précédentes, dans lequel les électrodes sont ramifiées et forment un ensemble d'électrodes interdigité.

6. Procédé selon l'une des revendications 1, 2 ou 4, dans lequel les électrodes sont disposées l'une au-dessus de l'autre.

7. Procédé selon l'une des revendications précédentes, dans lequel le champ électrique est un champ électrique alternatif.

8. Procédé selon l'une des revendications précédentes, dans lequel le transfert comprend que les nanoparticules semi-conductrices allongées alignées sont transférées de la surface du substrat sur une surface d'un support intermédiaire, puis de la surface du support intermédiaire sur la surface du demi-produit de la diode électroluminescente.

9. Procédé selon la revendication 8, dans lequel le support intermédiaire est un tampon, un ruban adhésif thermodétachable ou un film polymère.

10. Procédé selon l'une des revendications 1 à 7, dans lequel le transfert comprend que la surface du substrat, sur laquelle les nanoparticules semi-conductrices allongées alignées sont présentes, est mise en contact avec la surface du demi-produit de la diode électroluminescente, puis le substrat est retiré du demi-produit de la diode électroluminescente, dans lequel les nanoparticules semi-conductrices allongées restent au moins en partie sur la surface du demi-produit de la diode électroluminescente.

11. Procédé selon l'une des revendications 1 à 7, dans lequel le transfert comprend l'application de plusieurs couches sur les nanoparticules semi-conductrices allongées présentes et orientées sur la surface du substrat, dans lequel lesdites couches forment le demi-produit de la diode électroluminescente, puis le retrait du substrat du demi-produit de la diode électroluminescente, dans lequel les nanoparticules semi-conductrices allongées restent au moins en partie sur la surface du demi-produit de la diode électroluminescente.

Figur 1

Figur 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7700200 B2
- US 10036921 B2
- US 9557573 B2
- WO 2015144288 A1
- US 2019165291 A1

**In der Beschreibung aufgeführte Nicht-Patentliteratur**

- **U. BANIN et al.** *Angew. Chem.*, 2018, vol. 130, 4354-4376
- **R. HIKMET et al.** *Adv. Mater.*, 2005, vol. 17, 1436-1439
- **Y. AMIT et al.** *Phys. Status Solidi A*, 2012, vol. 209 (2), 235-242
- **A. RIZZO et al.** *ACS Nano*, 2009, vol. 3, 1506-1512
- **P. YANG et al.** *Adv. Mater.*, 2014, vol. 26, 2137-2184